(19) **Europäisches Patentamt**
**European Patent Office**
**Office européen des brevets**

(11) **EP 1 018 215 B1**

(12) **EUROPEAN PATENT SPECIFICATION**

(45) Date of publication and mention
of the grant of the patent:
**13.03.2002 Bulletin 2002/11**

(51) Int Cl.⁷: $H03H\ 9/145$

(21) Application number: **98948991.9**

(22) Date of filing: **18.09.1998**

(86) International application number:
**PCT/EP98/05968**

(87) International publication number:
**WO 99/16167 (01.04.1999 Gazette 1999/13)**

(54) **UNIDIRECTIONAL SURFACE ACOUSTIC WAVE FILTER**

UNIDIREKTIONALES FILTER MIT AKUSTISCHEN OBERFLÄCHENWELLEN

FILTRE UNIDIRECTIONNEL A ONDES DE SURFACE

(84) Designated Contracting States:
**DE DK FI FR GB SE**

(30) Priority: **24.09.1997 RU 97115553**

(43) Date of publication of application:
**12.07.2000 Bulletin 2000/28**

(73) Proprietor: **CTS Corporation**
**Elkhart, IN 46514 (US)**

(72) Inventors:
• **CHVETS, Valeri Borisovitch**
**Moscow, 125581 (RU)**

• **ORLOV, Victor Semenovitch**
**Moscow, 115569 (RU)**
• **MAKAROV, Vladimir Michailovitch**
**Moscow, 109651 (RU)**

(74) Representative: **Hooiveld, Arjen Jan Winfried et al**
**Arnold & Siedsma**
**Sweelinckplein 1**
**2517 GK Den Haag (NL)**

(56) References cited:
**EP-A- 0 564 881**

## Description

Field of the Invention

The present invention generally relates to surface acoustic wave (SAW) filters, and, more particularly, to a unidirectional transducer for a SAW filter.

European patent application number 93104635.3 having a filing date of 22 March 1993 and a Publication number 0564881A1 by the same applicant discloses a low-loss acoustic wave filter having a piczoclectric substrate and first and second strongly unidirectional transducers acoustically coupled to each other. Each of the first and second unidirectional acoustic wave transducers also include an acoustic wave reflector and a weakly unidirectional acoustic wave transducer also coupled to the piezoelectric substrate.

Background of the Invention

Surface acoustic wave (SAW) filters have a number of applications in electronics. At corresponding frequencies, the acoustic wavelengths $\lambda$ are shorter than the lengths of electromagnetic waves. SAW technology is important for applications where miniaturization is important or desirable. For example, SAW filters are used in radio telephones where the small size and weight of the SAW filter is highly advantageous over conventional technologies. such as ceramic, dielectric and other filters.

In caliular phone systems, an insertion loss of the SAW filter should not exceed a range of about 3 to 10 dB at intermediate frequencies between 70 to 250 MHZ, and the insertion loss should not exceed a range of about 2 to 4 dB at radio frequencies between 800 to 1800 MHZ.

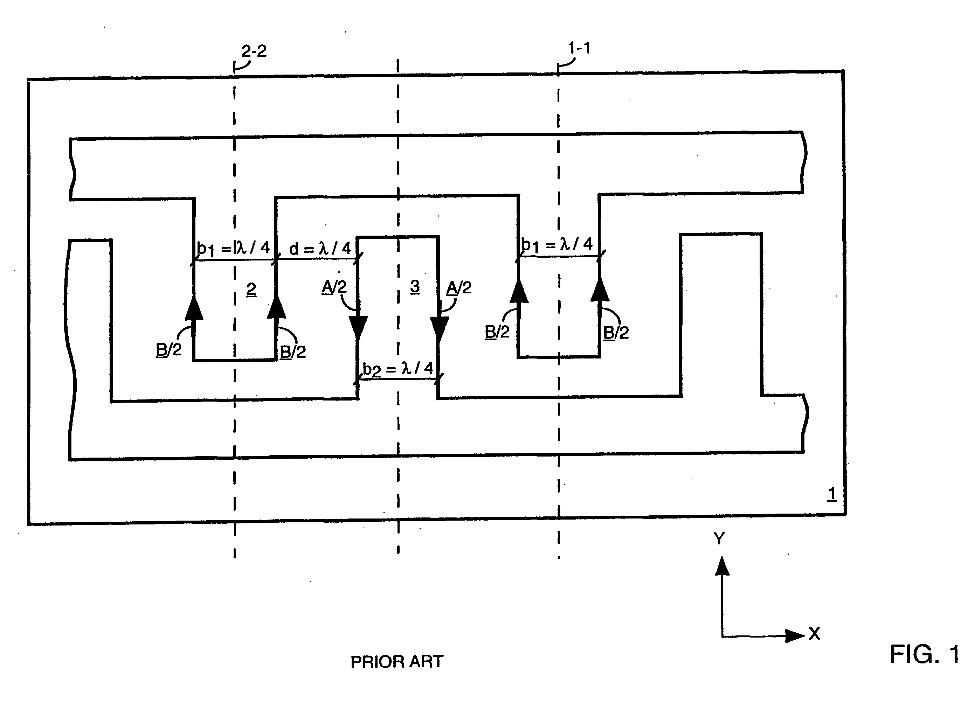

FIG. 1. is a simplified schematic diagram of a transducer of the pnor art. A SAW interdigital transducer (IDT) has piezoelectric acoustic guide 1 with exciting electrodes 2 and 3 located at its surface. When voltage is applied, electrodes 2 and 3 provide exciting in opposite phase. A useful reference is [1] Herbert Matthews (editor): "Surface Wave Filters", Wiley-Interscience Publication, 1981. The dimensions are related to the SAW-length $\lambda$ at an average operating frequency of the transducer. Electrode widths of electrodes 2 and 3 are $b_1 - b_2 = \lambda/4$ and distances d between the edges of adjacent electrodes 2 and 3 are also $\lambda/4$. Arrows $\underline{A}/2$ and $\underline{B}/2$ at the electrode edges illustrate so-called delta-sources ($\delta$-source) which approximate the excitation at a location where the electrical field has a maximum. Details are explained in reference [1].

The transformation between acoustic and electric energy and vice versa can be estimated by vector calculations known in the art. An efficiency parameter of the transformation is obtained for IDT of FIG. 1 as $E_1 = 2^{1/2} * A = 1.4 * A$ (superscript "1/2" for square root), wherein the absclute value "A" is a measure of the excitation strength at the electrode edges. $E_1$ is relatively high. However, the IDT-transducer suffers from relatively high insertion losses caused by the bidirectionality of the SAW radiation. Further, the IDT-transducer suffers from high distortions in the amplitude-to-frequency response (AFR) because incoming waves reaching the transducer from the right o input line 1-1 (dashed) or from the left of input line 2-2 (dashed) are reflected from the electrode edges and summed up in-phase. This is not wanted for many applications.

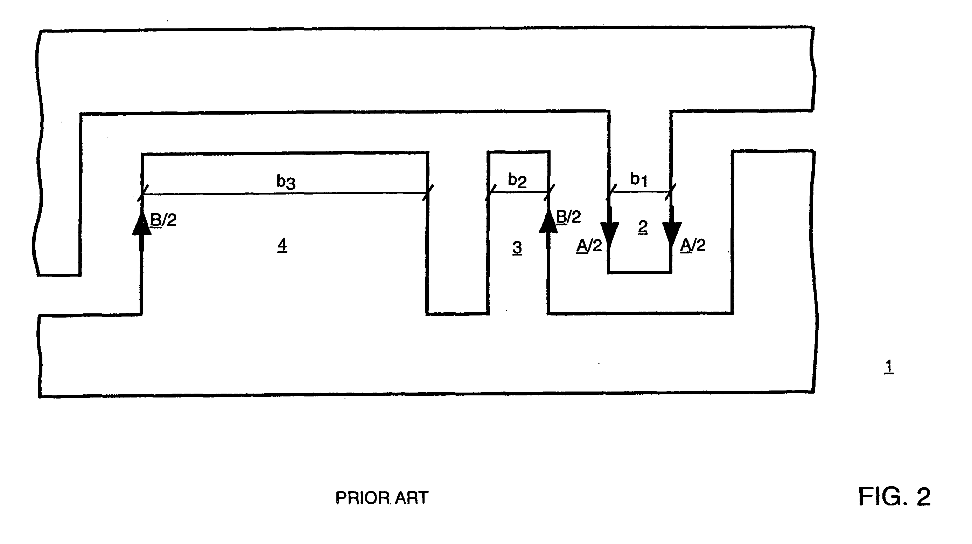

FIG. 2 is a simplified schematic diagram of a further transducer of the prior art. The transducer is a single phase unidirectional transducer (SPUDT) with distributed acoustic reflection (DART-type). A useful reference is [2] T. Kcoama et al.: "Design of low-loss SAW filters employing distributed acoustic reflection transducers", Proceedings of Ultrasonics Symposium 1986, pages 59-64. In FIGS. 1-2. like reference, numbers stand for like elements. The DART-transducer of FIG. 2 further comprises reflecting electrode 4. Widths are $b_1 = b_2 = \lambda/8$ for electrodes 2 and 3, and $b_3 = (3*\lambda)/8$ for reflecting electrode 4. Compared to the IDT-transducer of FIG. 1. the DART-transducer of FIG. 2 provides waves with a better directivity which means stronger wave propagation in X direction than in -X direction. Howevcr, with an efficiency $E_2 = 0.6 * A$, the DART-transducer exhibits a higher, unwanted insertion loss.

The present invention seeks to provide transducers for SAW filters having lower insertion losses and which further mitigate or avoid disadvantages and limitations of the prior art

Brief Description of the Drawings

FIG. 1 is a simplified schematic diagram of a transducer of the prior art;
FIG. 2 is a simplified schematic diagram of a further transducer of the prior art;
FIG. 3 is a simplified schematic diagram of a transducer according to the present invention; and
FIG. 4 is a simplified source vector diagram in a complex plane.

Detailed Description of a Preferred Embodiment

A transducer of the present invention can be used in filters operating at intermediate and carrier frequencies, used, for example, in radios, pagers, mobile communication systems etc. The present invention accommodates the above mentioned requirements concerning insertion loss for many applications.

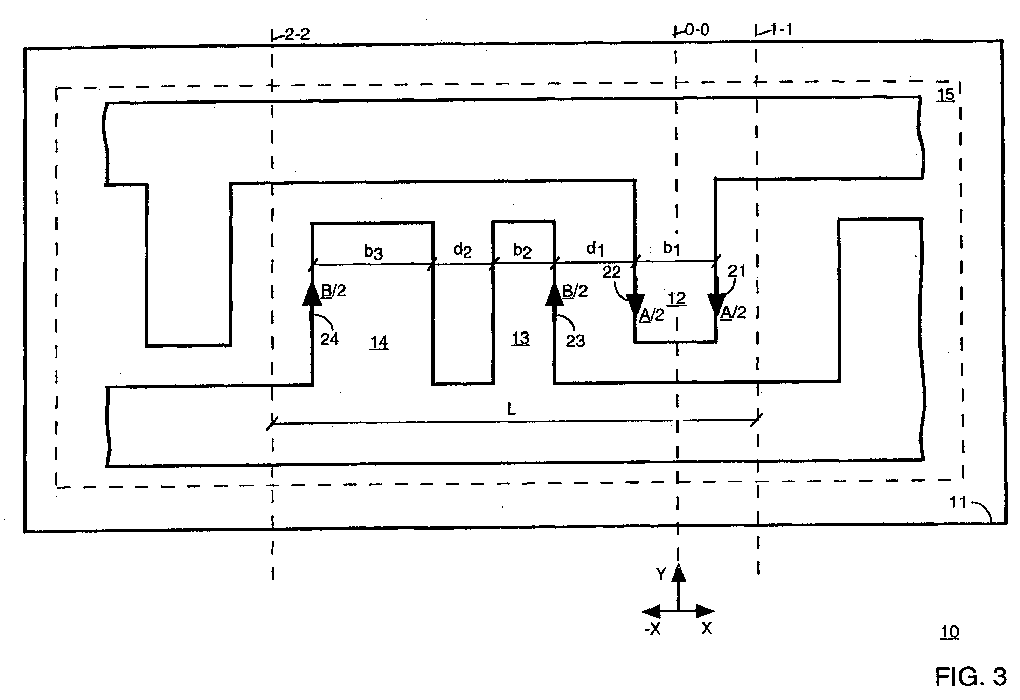

FIG. 3 is a simplified schematic diagram of transducer 10 according to the present invention. Transducer 10 is a single phase unidirectional transducer (SPUDT) for a SAW filter with triple-electrode sections (TES). Transducer 10 comprises piezoelectric acoustic guide 11 having elementary sections 15 (dashed frame) located on its working surface. Section 15 has exciting electrodes 12 and 13 and reflecting electrode 14. For convenience, a coordinate system illustrates a forward direction ("X") and a reverse direction ("-X"). The origin 0-0 (dashed) is given by a dashed line in the center of electrode 12. A section length L is defined as the distance between conventional boundaries 1-1 and 2-2 and substantially equals SAW length $\lambda$ at an average operating frequency of transducer 10 (L = $\lambda$). Electrode 12 has width $b_1$; electrode 13 has width $b_2$; and reflecting electrode 14 has width $b_3$. Width $b_1$ substantially equals $\lambda/6$; width $b_2$ substantially equals $\lambda/8$; and $b_3$ substantially equals $\lambda/4$. The distance $d_1$ between adjacent edges of electrodes 12 and 13 is $\lambda/6$; and the distance $d_2$ between adjacent edges of electrodes 13 and 14 is $\lambda/8$.

When an electric signal from an external generator (not shown) is applied to electrodes 12. 13 and 14, four $\delta$-sources 21 and 24 generate surface waves (SAWs). With the underscoring for "vector", and "A/2" or "B/2" standing for the excitation strength (conveniently, A= B), sources 21 and 22 ($\underline{A}/2$) and sources 23 and 24 ($\underline{B}/2$) are excited opposite in phase (antiphase).

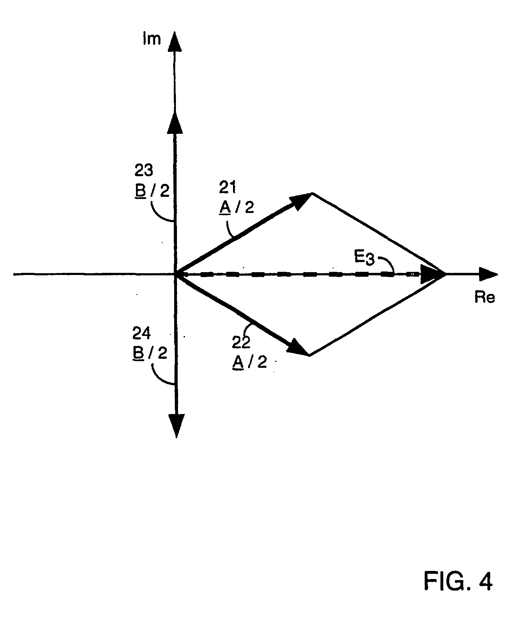

FIG. 4 is a simplified source vector diagram in a complex plane with imaginary part (Im) and real part (Re). For a convenient analysis of transducer 10, sources 21 to 24 are combined to a single equivalent source $\underline{E}_3$ (dashed arrow) having a conventional excitation center at X = 0. As illustrated in FIG. 4, the sources A/ 2 and B/2 have equal amplitudes but different phases. Referred to the coordinate origin 0-0 (cf. FIG. 3, dashed line), source 21 (in FIG. 3 at the right side of electrode 2) is advanced by $\lambda/12$ ($\varphi_{21} = \omega * t = + 30°$) and source 22 (left side of electrode 2) lags behind by $\lambda/12$ ($\varphi_{21} = - \omega * t = - 30°$). Source 23 (right side of electrode 13) lags behind by 90° and the source 24 (left side of electrode 14) lags behind by 270°, thus sources 23 and 24 equalizing in origin 0-0. Applying vector analysis known in the art. vector $\underline{E}_3$ has a magnitude $E_3$ of (superscript "1/2" for square root):

$$E_3 = (3^{1/2} / 2)* A = 0.87 * A$$

Compared to the DART-transducer of the part art (cf. FIG. 2), transducer 10 of the present invention has a 46% higher efficiency.

A filter with transducers 10 according to the present invention (cf. FIG. 3) was compared to a filter with a DART-transducer (cf. FIG. 2) of the prior art. Both filters were dimensioned as intermediate frequency filters having a center frequency $f_0$ = 112.32 MHZ with a 3 dB passband of $\Delta f$ = 1.2 MHZ. Such filters are used in cordless phones according to the European DECT standard. Both filters were manufactured on quartz substrates cut in ST-direction. For both filters, load impedances were 50 Ohm. The insertion loss of the filter according to the present invention was 1.2 to 1.5 dB lower than the insertion loss of the DART-filter of the prior art.

While the invention has been described in terms of particular structures and devices, those of skill in the art will understand based on the description herein that it is not limited merely to such examples and that the full scope of the invention is properly determined by the claims that follow.

**Claims**

1. A unidirectional surface acoustic wave, SAW, transducer (10) with a piezoelectric carrier (11) having first and second elements (15) arranged on the surface of and aligned parallel to each other, each element having a first (12) exciting electrode, a second exciting electrode (13) opposite in phase to said first (12) exciting electrode and a reflecting electrode (14), said elements (15) having a combined width equal to the SAW length $\lambda$ at an average operating frequency. said transducer **characterized in that** in each element the width (b1) of said first exciting electrode (12) equals $\lambda/6$ and the width (b2) of said second exciting clectrode (13) equals $\lambda/8$, the width (b3) of said reflecting electrode (14) equals $\lambda/4$, wherein a first distance between adjacent parallel edges of said first and second exciting electrodes (12. 13) equals $\lambda/6$, and a second distance between adjacent parallel edges of said second exciting electrode (13) and said reflecting electrode (14) equals $\lambda/8$.

2. SAW-transducer having a first exciting electrode (12), a second exciting electrode (13) opposite in phase to said first (12) exciting electrode, and a reflecting electrode (14), each of said first exciting electrode (12), second exciting electrode (13), and reflecting electrode (14) aligned parallel to each other, said SAW-transducer **characterized in that**:

   • said first electrode has a first width of $\lambda/6$. wherein $\lambda$ is the SAW length at an average operating frequency of the SAW-transducer,
   • said second electrode has a second width of $\lambda/8$,
   • said reflecting electrode has a third width of $\lambda/4$,
   • a first distance between adjacent parallel edges of said first and second electrodes is $\lambda/6$, and
   • a second distance between adjacent parallel edges of said second electrode and said reflecting electrode is $\lambda/8$.

**Patentansprüche**

1. Unidirektionaler Oberflächen-Schallwellen-Wandler, SAW-Wandler, (10) mit einem piezoelektrischen Träger (11), der ein erstes und ein zweites Element (15) aufweist, die auf der Oberfläche angeordnet und parallel zueinander ausgerichtet sind, wobei jedes Element eine erste (12) Anregungselektrode, eine zweite Anregungselektrode (13), die zur ersten (12) Anregungselektrode eine entgegengesetzte Phase aufweist und eine Reflektionselektrode (14) aufweist, wobei die Elemente (15) eine kombinierte Breite aufweisen, die gleich der SAW-Länge $\lambda$ bei einer mittleren Betriebsfrequenz ist, **dadurch gekennzeichnet, daß** in jedem Element die Breite (b1) der ersten Anregungselektrode (12) gleich $\lambda/6$ und die Breite (b2) der zweiten Anregungselektrode (13) gleich $\lambda/8$ ist, die Breite (b3) der Reflektionselektrode (14) gleich $\lambda/4$ ist, und daß ein erster Abstand zwischen benachbarten parallelen Rändern der ersten und der zweiten Anregungselektrode (12, 13) gleich $\lambda/6$ ist und ein zweiter Abstand zwischen benachbarten parallelen Rändern der zweiten Anregungselektrode (13) und der Reflektionselektrode (14) gleich $\lambda/8$ ist.

2. SAW-Wandler mit einer ersten Anregungselektrode (12), einer zweiten Anregungselektrode (13), die zu der ersten Anregungselektrode (12) eine entgegengesetzte Phase aufweist, und einer Reflektionselektrode (14), wobei die erste Anregungselektrode (12), die zweite Anregungselektrode (13) und die Reflektionselektrode (14) parallel zueinander ausgerichtet sind, **dadurch gekennzeichnet, daß**

    die erste Elektrode eine Breite von $\lambda/6$ aufweist, wobei $\lambda$ die SAW-Länge bei einer mittleren Betriebsfrequenz des SAW-Wandlers ist,
    die zweite Elektrode eine zweite Breite von $\lambda/8$ aufweist,
    die Reflektionselektrode eine dritte Breite von $\lambda/4$ aufweist,
    ein erster Abstand zwischen benachbarten parallelen Rändern der ersten und der zweiten Elektrode $\lambda/6$ beträgt, und
    ein zweiter Abstand zwischen benachbarten parallelen Rändern der zweiten Elektrode und der Reflektionselektrode $\lambda/8$ beträgt.

## Revendications

1. Transducteur (10) unidirectionnel à onde acoustique de surface SAW comportant un vecteur piézoélectrique (11) comportant un premier et un second éléments (15) disposés sur la surface en étant alignés parallèlement l'un à l'autre, chaque élément comportant une première électrode (12) d'excitation, une seconde électrode (13) d'excitation en opposition de phase avec ladite première électrode (12) d'excitation et une électrode (14) de réflexion, lesdits éléments (15) présentant une largeur combinée égale à la longueur d'onde SAW $\lambda$ sous une fréquence de fonctionnement moyenne, ledit transducteur étant **caractérisé en ce que** dans chaque élément la largeur (b1) de ladite première électrode d'excitation (12) est égale à $\lambda/6$ et la largeur (b2) de ladite seconde électrode d'excitation (13) est égale à $\lambda/8$, la largeur (b3) de ladite électrode de réflexion (14) est égale à $\lambda/4$, où une première distance entre les bords parallèles adjacents de ladite première et de ladite seconde électrodes d'excitation (12,13) est égale à $\lambda/6$, et une seconde distance entre les bords parallèles de ladite seconde électrode d'excitation (13) et ladite électrode de réflexion (14) est égale à $\lambda/8$.

2. Transducteur SAW comportant une première électrode d'excitation (12), une seconde électrode d'excitation (13) en opposition de phase avec ladite première électrode d'excitation (12), et une électrode de réflexion (14), chacune de ladite première électrode d'excitation (12), seconde électrode d'excitation (13), et électrode de réflexion (14) étant alignée parallèlement chacune avec chaque autre, ledit transducteur SAW étant **caractérisé en ce que** :

    ladite première électrode a une largeur de $\lambda/6$, où $\lambda$ est la longueur SAW à une fréquence de fonctionnement moyenne du transducteur SAW,
    ladite seconde électrode a une seconde largeur de $\lambda/8$,
    ladite électrode de réflexion a une troisième largeur de $\lambda/4$,
    une première distance entre les bords parallèles adjacents de ladite première et seconde électrodes est égale à $\lambda/6$, et
    une seconde distance entre les bords parallèles adjacents de ladite seconde électrode et de ladite électrode de réflexion est égale à $\lambda/8$.

PRIOR ART

FIG. 1

EP 1 018 215 B1

FIG. 2

PRIOR ART

FIG. 3

EP 1 018 215 B1

FIG. 4